# EUROPEAN PATENT APPLICATION

(11) **EP 4 203 064 A1**
(43) Date of publication of application: **28.06.2023**
(21) Application number: 22215156.5
(22) Date of filing: 20.12.2022
(51) Int. Cl.: H01L 29/423, H01L 29/778, H01L 21/338, H01L 29/40, H01L 29/08, H01L 29/20

(54) **SEMICONDUCTOR DEVICE WITH A GATE ELECTRODE HAVING MULTIPLE REGIONS AND METHOD OF FABRICATION THEREFOR**

(30) Priority: 24.12.2021 US 202117561793
(71) Applicant: NXP USA, Inc., Austin TX 78735 (US)
(72) Inventor: Grote, Bernhard, 5656 AG Eindhoven (NL); Kabir, Humayun, 5656 AG Eindhoven (NL); Green, Bruce McRae, 5656 AG Eindhoven (NL); Khalil, Ibrahim, 5656 AG Eindhoven (NL)
(74) Representative: Miles, John Richard

(57) **Abstract**

A semiconductor device includes a semiconductor substrate (110), a first dielectric layer (130) disposed over the upper surface of the semiconductor substrate, a second dielectric layer (150) disposed over the first dielectric layer, a third dielectric layer (155) disposed over the second dielectric layer, a lower opening (136) formed in the first dielectric layer, an upper opening (158) formed in the second dielectric layer and the third dielectric layer, wherein at least a portion of the upper opening overlaps a portion of the lower opening, and a control electrode (160) formed within at least a portion of the lower opening and within a portion of the upper opening, wherein a portion of the control electrode is formed over the third dielectric layer.

## Description

### TECHNICAL FIELD

Embodiments of the subject matter described herein relate generally to semiconductor devices with gate electrodes and methods for fabricating such devices.

### BACKGROUND

Semiconductor devices find application in a wide variety of electronic components and systems. High power, high frequency transistors find application in radio frequency (RF) systems and power electronics systems. Gallium nitride (GaN) device technology is particularly suited for these RF power and power electronics applications due to its superior electronic and thermal characteristics. In particular, the high electron velocity and high breakdown field strength of GaN make devices fabricated from this material ideal for RF power amplifiers and high-power switching applications. The design of gate electrodes in GaN devices plays a critical role in achieving the necessary device performance for various RF and power applications. Accordingly, there is a need for GaN devices with gate electrodes tailored to meet device performance requirements for a given application.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a cross-sectional, side view of an exemplary GaN heterojunction field effect transistor (HFET) in accordance with an embodiment;
FIG. 2 is a cross-sectional, side view of an exemplary GaN heterojunction field effect transistor (HFET) in accordance with an embodiment;
FIG. 3 is a process flow diagram describing a method for fabricating the GaN heterojunction field effect transistor (HFET) devices of FIGs 1-2 in accordance with an embodiment;
FIG. 4 is a cross-sectional, side view of a fabrication step for producing a GaN HFET device, in accordance with embodiments of the method of fabrication;
FIGs 5A, 5B, 5C, and 5D are cross-sectional, side views of fabrication steps for producing a GaN HFET device, in accordance with embodiments of the method of fabrication;
FIG. 6 is a cross-sectional, side view of a fabrication step for producing a GaN HFET device, in accordance with embodiments of the method of fabrication;
FIGs 7A, 7B, and 7C are cross-sectional, side views of fabrication steps for producing a GaN HFET device, in accordance with embodiments of the method of fabrication;
FIG. 8 is a cross-sectional, side view of a fabrication step for producing a GaN HFET device, in accordance with embodiments of the method of fabrication;
FIG. 9 is a cross-sectional, side view of a fabrication step for producing a GaN HFET device, in accordance with embodiments of the method of fabrication;
FIG. 10 is a cross-sectional, side view of a fabrication step for producing a GaN HFET device, in accordance with embodiments of the method of fabrication;
FIGs 11A, 11B, 11C, and 11D are cross-sectional, side views of fabrication steps for producing a GaN HFET device, in accordance with embodiments of the method of fabrication;
FIGs 12A and 12B are cross-sectional, side views of fabrication steps for producing a GaN HFET device, in accordance with embodiments of the method of fabrication;
FIGs 13A and 13B are cross-sectional, side views of fabrication steps for producing a GaN HFET device, in accordance with embodiments of the method of fabrication;
FIGs 14A and 14B are cross-sectional, side views of fabrication steps for producing a GaN HFET device, in accordance with embodiments of the method of fabrication;
FIGs 15A and 15B are cross-sectional, side views of fabrication steps for producing a GaN HFET device, in accordance with embodiments of the method of fabrication;
FIGs 16A and 16B are cross-sectional, side views of fabrication steps for producing a GaN HFET device, in accordance with embodiments of the method of fabrication; and
FIGs 17A and 17B are cross-sectional, side views of fabrication steps for producing a GaN HFET device, in accordance with embodiments of the method of fabrication.

### DETAILED DESCRIPTION

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

In one aspect, an embodiment may include a semiconductor device that may include a semiconductor device that may include semiconductor substrate comprising an upper surface and a channel. A first dielectric layer may be disposed over the upper surface of the semiconductor substrate, a second dielectric layer may be disposed over the first dielectric layer, and a third dielectric layer may be disposed over the second dielectric layer, according to an embodiment. In an embodiment, a lower opening may be formed in the first dielectric layer. An upper opening may be formed in the second dielectric layer and the third dielectric layer, wherein at least a portion of the upper opening may overlap a portion of the lower opening, according to an embodiment. In an embodiment, a control electrode may be formed within at least a portion of the lower opening and within a portion of the upper opening, wherein a portion of the control electrode may be formed over the third dielectric layer.

In another aspect, an embodiment may include a gallium nitride (GaN) transistor device that may include a semiconductor substrate that includes gallium nitride. The semiconductor substrate may include an upper surface and a channel. A first dielectric layer may be disposed over the upper surface of the semiconductor substrate, a second dielectric layer may be disposed over the first dielectric layer, and a third dielectric layer may be disposed over the first dielectric layer, according to an embodiment. In an embodiment, a source electrode and a drain electrode may be configured to support current flow through the channel and may be formed over the semiconductor substrate within source-drain openings formed in the first dielectric layer. A lower opening may be formed in the first dielectric layer between the source electrode and the drain electrode, according to an embodiment. In an embodiment, an upper opening may be formed in the second dielectric layer and the third dielectric layer, wherein at least a portion of the upper opening may overlap a portion of the lower opening. A gate electrode may be formed over the semiconductor substrate between the source electrode and the drain electrode, within at least a portion of the lower opening and within a portion of the upper opening, and configured to control current flow through the channel, according to an embodiment. In an embodiment, the gate electrode may include a first gate region formed within the lower opening and a second gate region formed above the first gate region. The second gate region may include a first protruding region extending laterally over the first dielectric layer between the lower opening and the source electrode and a second protruding region extending over the first dielectric layer between the lower opening and the drain electrode, according to an embodiment. In an embodiment, a third gate region may be formed above the second gate region. The third gate region may include a third protruding region that extends laterally over the third dielectric layer between the upper opening and the source electrode. In one or more embodiments, the third gate region may include a fourth protruding region extending over the third dielectric layer between the upper opening and the drain electrode. In one or more embodiments, the second dielectric layer and the third dielectric layer may terminate at an end of the third protruding region. In one or more embodiments, a fourth dielectric layer may be formed over at least a portion of the gate electrode, and wherein a field plate is formed over the fourth dielectric layer, adjacent the gate electrode, and between the gate electrode and the drain electrode.

In still another aspect, an embodiment may include a method of forming a forming a gallium nitride transistor. In an embodiment, the method may include forming a semiconductor substrate comprising gallium nitride and further comprising an upper surface and a channel. The method may further include forming a first dielectric layer over the upper surface of the semiconductor substrate and forming source-drain openings in the first dielectric layer, according to an embodiment. An embodiment of the method may include forming a source electrode and a drain electrode over the semiconductor substrate within the source-drain openings. The method may include forming a second dielectric layer over the first dielectric layer and forming a third dielectric a third layer over the second dielectric layer, according to an embodiment. An embodiment of the method may include forming an upper opening in the third dielectric layer and the second dielectric layer between the source electrode and the drain electrode and forming a lower opening in the first dielectric layer, wherein at least a portion of the upper opening overlaps a portion of the lower opening. The method may include forming a gate electrode, according to an embodiment. In an embodiment, forming the gate electrode may include forming a first gate region within the lower opening and forming a second gate region above the first gate region. Forming the second gate region may include forming a first protruding region extending over the first dielectric layer between the lower opening and the source electrode and a forming a second protruding region extending over the first dielectric layer between the lower opening and the drain electrode, according to an embodiment. Forming the gate electrode may further include forming a third gate region above the second gate region, according to an embodiment. In an embodiment, forming the third gate region may include forming a third protruding region that extends over the third dielectric layer between the upper opening and the source electrode. In one or more embodiments, the method may include forming the first dielectric layer includes forming silicon nitride and forming the second dielectric layer in includes forming a material selected from the group consisting of silicon dioxide, tetraethyl orthosilicate, organo-silicate glass, and porous silicon dioxide.

In one or more embodiments, the second dielectric layer and the third dielectric layer may be etched to terminate at a terminating end of the third protruding region. In one or more embodiments, the method may include forming a hard mask layer within the upper opening, wherein the hard mask layer is used to form the lower opening.

In one or more embodiments, the method may include forming a fourth dielectric layer over at least a portion of the gate electrode. In one or more embodiments, the method may include includes forming a field plate over the fourth dielectric layer, adjacent the gate electrode, and between the gate electrode and the drain electrode.

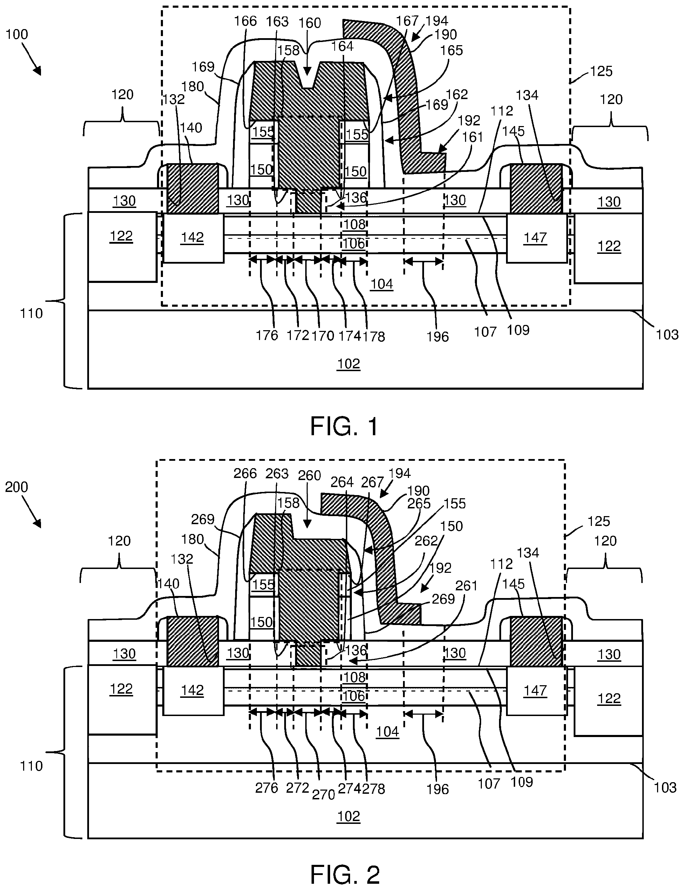

FIG. 1 is a cross-sectional, side view of an exemplary GaN heterojunction field effect transistor (HFET) device 100 in accordance with an embodiment. In an embodiment, the GaN HFET device 100 may include a semiconductor substrate 110, one or more isolation regions 120, an active region 125, a first dielectric layer 130, a source electrode (i.e., "first current-carrying electrode") 140, a drain electrode (i.e., "second current-carrying electrode") 145, a second dielectric layer 150, a third dielectric layer 155, a gate electrode 160 (i.e., "control electrode"), a fourth dielectric layer 180, and a field plate 190. As is described more fully below, the GaN HFET device 100 may be substantially contained within the active region 125 defined by the isolation regions 120, with the first dielectric layer 130, the source electrode 140, the drain electrode 145, the second dielectric layer 150, the third dielectric layer 155, the gate electrode 160, the fourth dielectric layer 180, and the field plate 190 may be disposed over the semiconductor substrate 110.

In an embodiment, the semiconductor substrate 110 may include a host substrate 102, a buffer layer 104 disposed over the host substrate 102, a channel layer 106 disposed over the buffer layer 104, a barrier layer 108 disposed over the channel layer 106, and a cap layer 109 disposed over the channel layer 106. In an embodiment, the host substrate 102 may include silicon carbide (SiC). In other embodiments, the host substrate 102 may include other materials such as sapphire, silicon (Si), GaN, aluminum nitride (AlN), diamond, poly-SiC, silicon on insulator, gallium arsenide (GaAs), indium phosphide (InP), and other substantially insulating or high resistivity materials. A nucleation layer (not shown) may be formed on an upper surface 103 of the host substrate 102 between the buffer layer 104 and the host substrate 102. In an embodiment, the nucleation layer may include AlN. The buffer layer 104 may include a number of group III-N semiconductor layers and is supported by the host substrate 102. Each of the semiconductor layers of the buffer layer 104 may include an epitaxially grown group III-nitride epitaxial layer. The group-III nitride epitaxial layers that make up the buffer layer 104 may be nitrogen (N)-face or gallium (Ga)-face material, for example. In other embodiments, the semiconductor layers of the buffer layer 104 may not be epitaxially grown. In still other embodiments, the semiconductor layers of the buffer layer 104 may include Si, GaAs, InP, or other suitable materials.

In an embodiment, the buffer layer 104 may be grown epitaxially over the host substrate 102. The buffer layer 104 may include at least one AlGaN mixed crystal layer having a composition denoted by Al_{X}Ga_{1-X}N with an aluminum mole fraction, X, that can take on values between 0 and 1. The total thickness of the buffer layer 104 with all of its layers may be between about 200 angstroms and about 100,000 angstroms although other thicknesses may be used. A limiting X value of 0 yields pure GaN while a value of 1 yields pure aluminum nitride (AlN). An embodiment may include a buffer layer 104 disposed over the host substrate and nucleation layer (not shown). The buffer layer 104 may include additional Al_{X}Ga_{1-X}N layers. The thickness of the additional AlxGai-xN layer(s) may be between about 200 angstroms and about 50,000 angstroms though other thicknesses may be used. In an embodiment, the additional Al_{X}Ga_{1-X}N layers may be configured as GaN (X=0) where the Al_{X}Ga_{1-X}N is not intentionally doped (NID). The additional Al_{X}Ga_{1-X}N layers may also be configured as one or more GaN layers where the one or more GaN layers are intentionally doped with dopants that may include iron (Fe), chromium (Cr), carbon (C) or other suitable dopants that render the buffer layer 104 substantially insulating or high resistivity. The dopant concentration may be between about 10¹⁷ cm⁻³ and 10¹⁹ cm⁻³ though other higher or lower concentrations may be used. The additional Al_{X}Ga_{1-X}N layers may be configured with X=0.01 to 0.10 where the Al_{X}Ga_{1-X}N is NID or, alternatively, where the Al_{X}Ga_{1-X}N is intentionally doped with Fe, Cr, C, or other suitable dopant species. In other embodiments (not shown), the additional layers may be configured as a superlattice where the additional layers include a series of alternating NID or doped Al_{X}Ga_{1-X}N layers where the value of X takes a value between 0 and 1. In still other embodiments, the buffer layer 104 may also include one or more indium gallium nitride (InGaN) layers, with composition denoted In_{Y}Ga_{1-Y}N, where Y, the indium mole fraction, may take a value between 0 and 1. The thickness of the InGaN layer(s) may be between about 50 angstroms and about 2,000 angstroms, though other thicknesses may be used.

In an embodiment, a channel layer 106 may be formed over the buffer layer 104. The channel layer 106 may include one or more group III-N semiconductor layers and may be supported by the buffer layer 104. The channel layer 106 may include an Al_{X}Ga_{1-X}N layer where X takes on values between 0 and 1. In an embodiment, the channel layer 106 is configured as GaN (X=0) although other values of X may be used without departing from the scope of the inventive subject matter. The thickness of the channel layer 106 may be between about 50 angstroms and about 10,000 angstroms though other thicknesses may be used. The channel layer 106 may be NID or, alternatively, may include Si, germanium (Ge), C, Fe, Cr, or other suitable dopants. The dopant concentration may be between about 10¹⁵ cm⁻³ and about 10¹⁹ cm⁻³ though other higher or lower concentrations may be used. In other embodiments, the channel layer 106 may include NID or doped In_{Y}Ga_{1-Y}N, where Y, the indium mole fraction, may take a value between 0 and 1.

A barrier layer 108 may be formed over the channel layer 106 in accordance with an embodiment. The barrier layer 108 may include one or more group III-N semiconductor layers and is supported by the channel layer 106. In some embodiments, the barrier layer 108 may have a larger bandgap and larger spontaneous polarization than the channel layer 106 and, when the barrier layer 108 is in direct contact with the channel layer 106, a channel 107 is created in the form of a two-dimensional electron gas (2-DEG) within the channel layer 106 near the interface between the channel layer 106 and barrier layer 108. In addition, strain between the barrier layer 108 and channel layer 106 may cause additional piezoelectric charge to be introduced into the 2-DEG and channel 107. The barrier layer 108 may include at least one NID Al_{X}Ga_{1-X}N layer where X takes on values between 0 and 1. In some embodiments, X may take a value of 0.1 to 0.35, although other values of X may be used. The thickness of the barrier layer 108 may be between about 50 angstroms and about 1000 angstroms though other thicknesses may be used. The barrier layer 108 may be NID or, alternatively, may include Si, Ge, C, Fe, Cr, or other suitable dopants. The dopant concentration may be between about 10¹⁶ cm⁻³ and 10¹⁹ cm⁻³ though other higher or lower concentrations may be used. In an embodiment, an additional AlN interbarrier layer (not shown) may be formed between the channel layer 106 and the barrier layer 108, according to an embodiment. The AlN interbarrier layer may increase the channel charge and improve the electron confinement of the resultant 2-DEG. In other embodiments, the barrier layer 108 may include indium aluminum nitride (InAlN) layers, denoted In_{Y}Al_{1-Y}N, where Y, the indium mole fraction, may take a value between about 0.1 and about 0.2 though other values of Y may be used. In the case of an InAlN barrier, the thickness of the barrier layer 108 may be between about 30 angstroms and about 1000 angstroms though other thicknesses may be used. In the case of using InAlN to form the barrier layer 108, the InAIN may be NID or, alternatively, may include Si, Ge, C, Fe, Cr, or other suitable dopants. The dopant concentration may be between about 10¹⁶ cm⁻³ and about 10¹⁹ cm⁻³ though other higher or lower concentrations may be used.

In an embodiment illustrated in FIG. 1, a cap layer 109 may be formed over the barrier layer 108. The cap layer 109 may present a stable surface for the semiconductor substrate 110 and may protect the surface of the semiconductor substrate 110 from chemical and environmental exposure incident to wafer processing. The cap layer 109 may include one or more group III-N semiconductor layers and is supported by the barrier layer 108. In an embodiment, the cap layer 109 is GaN. The thickness of the cap layer 109 may be between about 5 angstroms and about 100 angstroms though other thicknesses may be used. The cap layer 109 may be NID or, alternatively, may include Si, Ge, C, Fe, Cr, or other suitable dopants. The dopant concentration may be between about 10¹⁶ cm⁻³ and 10¹⁹ cm⁻³ though other higher or lower concentrations may be used. Without departing from the scope of the inventive subject matter, it should be appreciated that the choice of materials and arrangement of layers to form the semiconductor substrate 110 is exemplary. It should be appreciated that the inclusion of the host substrate 102, the buffer layer 104, the channel layer 106, the barrier layer 108, and the cap layer 109 into the semiconductor substrate 110 is exemplary and that the function and operation of the various layers may be combined and may change depending on the materials used in any specific embodiment. For example, in some embodiments, the cap layer 109 may be omitted (not shown). In other embodiments using N-polar materials, the channel layer 106 may be disposed over the barrier layer 108 to create a 2-DEG and channel 107 directly beneath the cap layer 109 and the gate electrode 160 (not shown). Still further embodiments may include semiconductor layers formed from materials including GaAs, gallium oxide (Ga₂O₃) aluminum gallium arsenide (AlGaAs), indium gallium arsenide (InGaAs), and aluminum indium arsenide (AlInAs) to form the semiconductor substrate 110.

One or more isolation regions 120 may be formed in the semiconductor substrate 110 to define an active region 125 above and along the upper surface 103 of the host substrate 102, according to an embodiment. The isolation regions 120 may be formed via an implantation procedure configured to damage the epitaxial and/or other semiconductor layers to create high resistivity regions 122 of the semiconductor substrate 110 rendering the semiconductor substrate 110 high resistivity or semi-insulating in those high resistivity regions 122 while leaving the crystal structure intact in the active region 125. In other embodiments, the isolation regions 120 may be formed by removing one or more of the epitaxial and/or other semiconductor layers of the semiconductor substrate 110 rendering the remaining layers of the semiconductor substrate 110 semi-insulating and leaving behind active region 125 "mesas" surrounded by high resistivity or semi-insulating isolation regions 120 (not shown). In still other embodiments, the isolation regions 120 may be formed by removing one or more of the epitaxial and/or other semiconductor layers of the semiconductor substrate 110 and then using ion implantation to damage and further enhance the semi-insulating properties of the remaining layers of the semiconductor substrate 110 and leaving behind active region 125 "mesas" surrounded by high resistivity or semi-insulating isolation regions 120 that have been implanted (not shown).

In an embodiment, a first dielectric layer 130 may be formed over the active region 125 and isolation regions 120. In an embodiment, the first dielectric layer 130 may be formed from one or more suitable materials including silicon dioxide (SiOz), silicon nitride (SiN), silicon oxynitride (SiON), aluminum oxide (Al₂O₃), aluminum nitride (AlN), and hafnium oxide (HfOz), though other substantially insulating materials may be used. In an embodiment, the first dielectric layer 130 may have a thickness of between 200 angstroms and 1000 angstroms. In other embodiments, the first dielectric layer 130 may have a thickness of between 50 angstroms and 10000 angstroms, though other thicknesses may be used.

In an embodiment, the source electrode 140 and the drain electrode 145 may be formed over and contact source and drain regions 142, 147 formed in semiconductor substrate 110 in the active region 125. The source electrode 140 and the drain electrode 145 may be formed inside a source opening 132 (i.e., "first current-carrying opening") and a drain opening 134 (i.e., "second current-carrying opening") formed in the first dielectric layer 130 and may be formed from one or more conductive layers. In some embodiments, ion implantation may be used to form ohmic contact to the channel 107 to create source and drain regions 142, 147. In an embodiment, the one or more conductive layers used to form source and drain electrodes 140, 145 may include titanium (Ti), gold (Au), Al, molybdenum (Mo), nickel (Ni), Si, Ge, platinum (Pt), tantalum (Ta), or other suitable materials. In other embodiments, the one or more conductive layers used to form source and drain electrodes 140, 145 may include titanium-tungsten (TiW), titanium-aluminum (TiAl), or titanium-tungsten nitride (TiWN). In an embodiment, the source electrode 140 and the drain electrode 145 may be formed over and in contact with the cap layer 109. In other embodiments (not shown), one or both of the source electrode 140 and the drain electrode 145 may be recessed through the cap layer 109 and extend partially through the barrier layer 108. In an embodiment, the source electrode 140 and the drain electrode 145 may be formed from a multi-layer stack. In an embodiment, the multi-layer stack used to form the source electrode 140 and the drain electrode 145 may include an adhesion layer and one or more layers, that when annealed, allows an ohmic contact to form between the channel 107 and the source and drain regions 142, 147. In an embodiment, the adhesion layer may include titanium (Ti), tantalum (Ta), silicon (Si), or other suitable materials. In an embodiment, the adhesion layer may have a work function that is below 4.5 electron-volts.

The second dielectric layer 150 may be disposed over the first dielectric layer, according to an embodiment. In an embodiment, the second dielectric layer 150 may be formed from one or more suitable materials including silicon dioxide (SiOz), tetraethyl orthosilicate (TEOS), organo-silicate glass, porous silicon dioxide, silicon nitride (SiN), silicon oxynitride (SiON), aluminum oxide (Al₂O₃), aluminum nitride (AlN), and hafnium oxide (HfOz), though other substantially insulating materials may be used. In an embodiment, the second dielectric layer 150 may include a low-k dielectric layer. As used herein, and in an embodiment, the term, "low-k dielectric layer" refers to a dielectric material having a relative permittivity below about 6. In an embodiment, the dielectric constant of the first dielectric layer may exceed the dielectric constant of the second dielectric layer 150. The lower dielectric constant for the second dielectric layer 150 that may be realized using a low-k dielectric layer may minimize the parasitic capacitance between the gate electrode 160 and the source electrode 140 and the field plate 190, for example. For example, in one embodiment, the first dielectric layer 130 may include SiN while the second dielectric layer 150 may include TEOS. In an embodiment, the second dielectric layer 150 may have a thickness of between 1000 angstroms and 10000 angstroms. In other embodiments, the second dielectric layer 150 may have a thickness of between 500 angstroms and 20000 angstroms, though other thicknesses may be used.

The third dielectric layer 155 may be disposed over the second dielectric layer 150, according to an embodiment. In an embodiment, the third dielectric layer 155 may be formed from one or more suitable materials including silicon dioxide (SiOz), silicon nitride (SiN), silicon oxynitride (SiON), aluminum oxide (Al₂O₃), aluminum nitride (AlN), and hafnium oxide (HfOz), though other substantially insulating materials may be used. In an embodiment, the third dielectric layer 155 may have a thickness of between 200 angstroms and 1000 angstroms. In other embodiments, the third dielectric layer 155 may have a thickness of between 50 angstroms and 5000 angstroms, though other thicknesses may be used.

In an embodiment, the gate electrode 160 may be formed over the semiconductor substrate 110 in the active region 125. A lower opening 136 may be formed in the first dielectric layer 130 between the source electrode 140 and the drain electrode 145, according to an embodiment. In an embodiment, an upper opening 158 may be formed in the second dielectric layer 150 and the third dielectric layer 155, wherein at least a portion of the upper opening 158 may overlap a portion of the lower opening 136. The gate electrode 160 may be formed over the semiconductor substrate 110 between the source electrode 140 and the drain electrode 145, within at least a portion of the lower opening 136 and within a portion of the upper opening 158 and configured to control current flow through the channel 107, according to an embodiment. In an embodiment, the gate electrode 160 may include a first gate region (i.e., "first region") 161 formed within the lower opening 136 and a second gate region (i.e., "second region") 162 formed above the first gate region 161 within the upper opening 158. The second gate region 162 may include a first protruding region 163 extending laterally over the first dielectric layer 130 between the lower opening 136 and the source electrode 140 and a second protruding region 164 extending over the first dielectric layer 130 between the lower opening 136 and the drain electrode, according to an embodiment. In an embodiment, a third gate region 165 may be formed above the second gate region 162. The third gate region 165 may include a third protruding region 166 that may extend laterally over the third dielectric layer 155 between the upper opening 158 and the source electrode 140. The third gate region 165 may include a fourth protruding region 167 extending over the third dielectric layer 155 between the upper opening 158 and the drain electrode 147, according to an embodiment.

In an embodiment, the gate electrode 160 may be characterized by a gate length 170 within the lower opening 136 and first and second protruding region lengths 163 and 164 and third and fourth protruding region lengths (i.e., "lateral lengths") 176 and 178, where the first and second protruding regions 163 and 164 may overlay the first dielectric layer 130 and the third and fourth protruding regions 166, 167 may overlay the third dielectric layer 155. In an embodiment, the gate length 170 may be between about 0.05 microns and about 1 micron. In other embodiments, the gate length 170 may be between about 0.02 microns and about 5 microns, though other suitable dimensions may be used. In an embodiment, the first and second protruding region lengths 172, 174 may be between about 0.02 microns and about 0.5 microns. In other embodiments, the first and second protruding region lengths 172, 174 may be between about 0.01 microns and 5 microns, though other suitable dimensions may be used. In an embodiment, the third and fourth protruding region lengths 176, 178 may be between about 0.02 microns and about 0.5 microns. In other embodiments, the third and fourth protruding region lengths 176, 178 may be between about 0.01 microns and 5 microns, though other suitable dimensions may be used.

Changes to the electric potential applied to the gate electrode 160 may shift the quasi Fermi level for the barrier layer 108 with respect to the quasi Fermi level for the channel layer 106 and thereby modulate the electron concentration in the channel 107 within the semiconductor substrate 110 under the gate electrode 160. One or more Schottky materials such as Ni, palladium (Pd), Pt, iridium (Ir), or Copper (Cu), may be combined with one or more of low stress conductive materials such as Au, Al, Cu, poly Si, or other suitable material(s) in a metal stack to form a gate electrode 160 for a low-loss, Schottky gate electrode 160 electrically coupled to channel 107, according to an embodiment.

In an embodiment, the second and third dielectric layers 150, 155 may extend from the edge of the upper opening 158 to the outer edges of the third and fourth protruding regions 166, 167. Outside edges of the second and third dielectric layers 150, 155 may be self-aligned with the outer edges of the third and fourth protruding regions 166, 167, according to an embodiment. In other embodiments (not shown), the second and third dielectric layers 150, 155 may extend beyond the outer edges of the third and fourth protruding regions 166, 167. In these other embodiment(s), the second and third dielectric layers 150, 155 may cover the first dielectric layer 130 and source and drain electrodes 140, 145.

In an embodiment, spacer layers 169 may be formed on the vertical edges of the gate electrode 160. The spacer layers 169 may contact the outside edges of the second and third dielectric layers 150, 155, according to an embodiment. In an embodiment, the spacer layers 169 may be formed from one or more suitable materials including silicon dioxide (SiOz), tetraethyl orthosilicate (TEOS), organo-silicate glass, porous silicon dioxide, silicon nitride (SiN), silicon oxynitride (SiON), aluminum oxide (Al₂O₃), aluminum nitride (AlN), and hafnium oxide (HfOz), though other substantially insulating materials may be used. One or more low-k dielectric materials may be used to form the spacer layers 169, according to an embodiment. In an embodiment, use of a low-k dielectric layer to form the spacer layers 169 may minimize the parasitic capacitance between the gate electrode 160 and the source electrode 140 and the field plate 190, for example. For example, and in one embodiment, where the first dielectric layer 130 may include SiN while the second dielectric layer 150 may include TEOS, the spacer layers 169 may include TEOS. In an embodiment, the spacer layers 169 have a thickness of between 1,000 angstroms and 10,000 angstroms. In other embodiments, the spacer layers 169 may have a thickness of between 500 angstroms and 20,000 angstroms, though other thicknesses may be used. In another embodiment (not shown) an etch stop layer may be formed over the gate electrode 160, either before or after forming the spacer layers 169. Where an etch stop layer is formed over the gate electrode 160 before forming the spacer layers 169, the etch stop layer may act to block the etch of the etchant used to form the spacer layers 169.

Without departing from the scope of the inventive subject matter, numerous other embodiments may be realized. The exemplary embodiment of FIG. 1 depicts the gate electrode 160 as being disposed over the semiconductor substrate 110. In other embodiments (not shown), the gate electrode 160 may be recessed through the cap layer 109 and extend partially into the barrier layer 108, increasing the electrical coupling of the gate electrode 160 to the channel 107 through the barrier layer 108. In other embodiments (not shown), the cap layer 109 may be omitted and the gate electrode 160 may contact the barrier layer 108 directly (not shown). In still other embodiments, the gate electrode 160 may be disposed over a gate dielectric that may be formed between the gate electrode 160 and the semiconductor substrate 110 to form a metal-insulator semiconductor field effect transistor (MISFET) device (not shown).

In an embodiment, a fourth dielectric layer 180 may be formed over at least a portion of the gate electrode 160. In an embodiment, the fourth dielectric layer 180 may be formed from one or more suitable materials including silicon dioxide (SiOz), tetraethyl orthosilicate (TEOS), organo-silicate glass, porous silicon dioxide, silicon nitride (SiN), silicon oxynitride (SiON), aluminum oxide (Al₂O₃), aluminum nitride (AlN), and hafnium oxide (HfOz), though other substantially insulating materials may be used. One or more low-k dielectric materials may be used to form the spacer layers 169, according to an embodiment. In an embodiment, use of a low-k dielectric layer to form the spacer layers 169 may minimize the parasitic capacitance between the gate electrode 160 and the source electrode 140 and the field plate 190, for example. For example, and in one embodiment, where the first dielectric layer 130 may include SiN while the second dielectric layer 150 may include TEOS, the spacer layers 169 may include TEOS. In an embodiment, the second dielectric layer 150 may have a thickness of between 1,000 angstroms and 10,000 angstroms. In other embodiments, the second dielectric layer 150 may have a thickness of between 500 angstroms and 20,000 angstroms, though other thicknesses may be used.

A field plate 190 may be formed over the fourth dielectric layer 180, adjacent the gate electrode 160, and between the gate electrode 160 and the drain electrode 145. In an embodiment, the field plate 190 may be formed over the first dielectric layer 130, adjacent the gate electrode 160, and between the gate electrode 160 and the drain electrode 145. In an embodiment, the field plate 190 may include a first field plate region 192 formed laterally adj acent the gate electrode 160 and that may contact the fourth dielectric layer 180 and a second field plate region 194 that contacts the fourth dielectric layer 180 in regions that surround the gate electrode 160. The field plate 190 may be characterized by a field plate length 196 that characterizes the lateral length of the first field plate region 192, according to an embodiment. In an embodiment, the field plate length 196 may be between about 0.1 microns and about 2 microns. In other embodiments, the field plate length 196 may be between 0.05 microns and 10 microns, though other suitable lengths may be used. In an embodiment, the field plate 190 may reduce the electric field and gate-drain feedback capacitance between the gate electrode 160 and the drain electrode 145.

In other embodiments, the field plate 190 may be formed in contact with the first dielectric layer 130 through one or more openings in the fourth dielectric layer 180 and dielectric layers below the fourth dielectric layer 180 (not shown). In these other embodiments, a field plate etch stop layer may be formed to block the etch of the fourth dielectric layer 180. The field plate etch stop layer may be formed as part of the first dielectric layer 130 (e.g., an AlN or Al2O3 layer formed over SiN) or may be deposited over the gate electrode 160 either before or after the formation of the spacer layers 169. In still other embodiments, the field plate 190 may be formed using a conductive layer, also used to form the source and drain electrodes 140, 145. In these embodiments, etching of the underlying dielectric layers in an opening including the fourth dielectric layer 180 as well as any other intervening dielectric layer(s) under the field plate 190 may be accomplished prior to forming the field plate 190.

In an embodiment, GaN HFET device 100 may be configured as a transistor finger wherein the source electrode 140, the drain electrode 145, gate electrode 160, and the field plate 190 may be configured as elongated elements forming a gate finger. The GaN HFET device 100 may be defined, in part, by isolation regions 120 in which a gate width of the gate finger (i.e., a dimension extending along an axis perpendicular to the plane of GaN HFET device 100 of Figure 1 is significantly larger than the gate length 170 of the gate electrode 160 (i.e., a dimension extending along an axis that is perpendicular to the width). In some embodiments, the gate width may be between about 50 microns and about 500 microns. In other embodiments, the gate width may be between about 1 microns and about 10,000 microns. In an embodiment, the field plate 190 may be electrically coupled to the same potential as the source electrode 140. The field plate 190 may be connected to the source electrode 140 using connections formed from extensions of the conductive material used to form the field plate 190 at one or more ends of device fingers in the isolation region 120 to the source electrode 140 (not shown).

In other embodiments, additional dielectric and metal layers may be formed over and adjacent to the GaN HFET device 100. In these other embodiments, these additional dielectric and metal layers may include passivation layers, interconnect metallization, additional active devices (e.g. devices with source electrodes, drain electrodes, gate electrodes and other elements), and additional circuitry, without limitation.

FIG. 2 is a cross-sectional, side view of an exemplary GaN heterojunction field effect transistor (HFET) device 200 in accordance with an embodiment. In an embodiment, the GaN HFET device 100 may include a semiconductor substrate 110, one or more isolation regions 120, an active region 125, a first dielectric layer 130, a source electrode 140, a drain electrode 145, a second dielectric layer 150, a third dielectric layer 155, a gate electrode 260 (i.e., "control electrode"), a fourth dielectric layer 180, and a field plate 190. Analogous to the GaN HFET device 100 of FIG. 1, the GaN HFET device 200 is substantially contained within the active region 125 defined by the isolation regions 120, wherein first dielectric layer 130, the source electrode 140, the drain electrode 145, the second dielectric layer 150, the third dielectric layer 155, the gate electrode 260, the fourth dielectric layer 180, and the field plate 190 may be disposed over the semiconductor substrate 110.

In an embodiment, the gate electrode 260 may be formed over the semiconductor substrate 110 in the active region 125. A lower opening 136 may be formed in the first dielectric layer 130 between the source electrode 140 and the drain electrode 145, according to an embodiment. In an embodiment, an upper opening 158 may be formed in the second dielectric layer 150 and the third dielectric layer 155, wherein at least a portion of the upper opening 158 may overlap a portion of the lower opening 136. The gate electrode 260 may be formed over the semiconductor substrate 110 between the source electrode 140 and the drain electrode 145, within at least a portion of the lower opening 136 and within a portion of the upper opening 158 and configured to control current flow through the channel 107, according to an embodiment. In an embodiment, the gate electrode 260 may include a first gate region 261 formed within the lower opening 136 and a second gate region 262 formed above the first gate region within the upper opening 158. The second gate region 262 may include a first protruding region 263 extending laterally over the first dielectric layer 130 between the lower opening 136 and the source electrode 140 and a second protruding region 264 extending over the first dielectric layer 130 between the lower opening 136 and the drain electrode, according to an embodiment. In an embodiment, a third gate region 265 may be formed above the second gate region 262. The third gate region 265 may include a third protruding region 266 that may extend laterally over the third dielectric layer 155 between the upper opening 158 and the source electrode 140, according to an embodiment.

In an embodiment, the third and fourth protruding region lengths 276, 278 may be unequal. For example, the third protruding region length 276 may be longer than the fourth protruding region length 278, according to an embodiment. In other embodiments (not shown), the third protruding region length 276 may be shorter than the fourth protruding region length 278.

In other embodiments (not shown), and in contrast to the GaN HFET device 100, 200 of FIGs 1 and 2, the third gate region 265 may not include a protruding region on the side of the third gate region 265, closest to the drain. Accordingly, a face (not shown) on side of the first gate region 261 and the second gate region 262, closest to the drain electrode 145 may be continuous. The lack of this protruding region may decrease gate-to-drain capacitance in these embodiments.

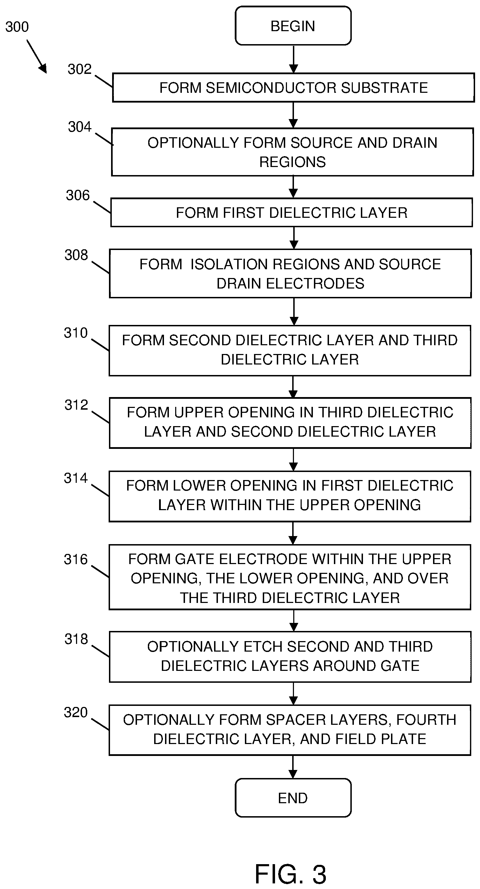

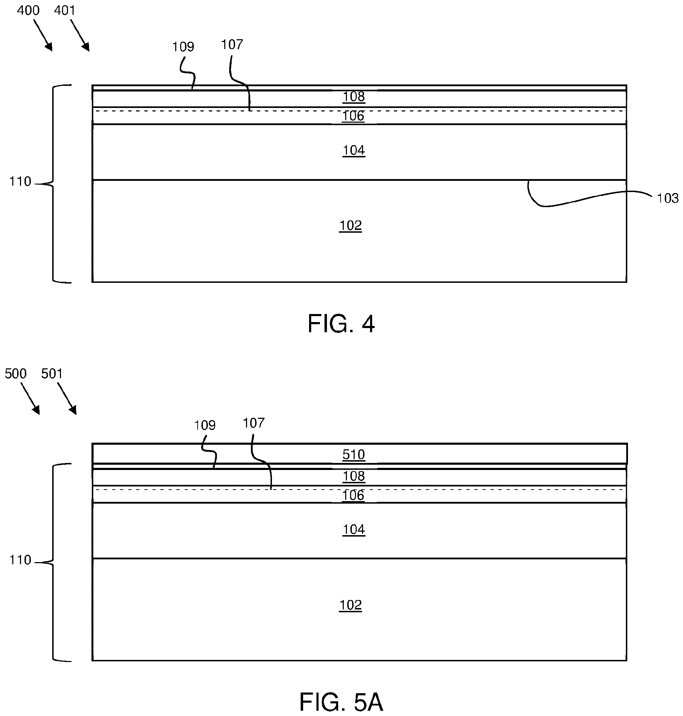

The flowchart 300 of FIG. 3 describes embodiments of methods for fabricating semiconductor devices (e.g., GaN HFET devices 100, 200 FIGs 1-2). FIG. 3 should be viewed alongside FIGs 4, 5A, 5B, 5C, 5D, 6, 7A, 7B, 7C, 8, 9, 10, 11A, 11B, 11C, 11D, 12A, 12B, 13A, 13B, 14A, 14B, 15A, 15B, 16A, 16B, 17A, 17B, 18A, and 18B which illustrate cross-sectional, side views of a series of fabrication steps for producing the semiconductor devices of FIGs 1-2, in accordance with an example embodiment.

In block 302 of FIG. 3, and as depicted in the step 400 of FIG. 4, an embodiment of the method may include forming a semiconductor substrate 110. In an embodiment, the step 400 may include providing a host substrate 102 and forming number of semiconductor layers on or over the host substrate 102. In an embodiment, the host substrate 102 may include SiC, or may include other materials such as sapphire, Si, GaN, AlN, diamond, poly-SiC, silicon on insulator, GaAs, InP, or other substantially insulating or high resistivity materials. Forming the semiconductor layers may include forming a nucleation layer (not shown) on or over an upper surface 103 of the host substrate 102, forming a buffer layer 104 on or over the nucleation layer, forming the channel layer 106 on or over the buffer layer 104, forming the barrier layer 108 on or over the channel layer 106, and forming the cap layer 109 on or over the barrier layer 108. As discussed previously, embodiments of the buffer layer 104, the channel layer 106, the barrier layer 108, and the cap layer 109 may include materials selected from AlN, GaN, AlGaN, InAlN, InGaN, or other suitable materials. The semiconductor layers 104, 106, 108, and 109 may be grown using one of metal-organo chemical vapor deposition (MOCVD), molecular beam epitaxy (MBE), hydride-vapor phase epitaxy (HVPE) or a combination of these techniques, although other suitable techniques may alternatively be used. Semiconductor substrate 110 results.

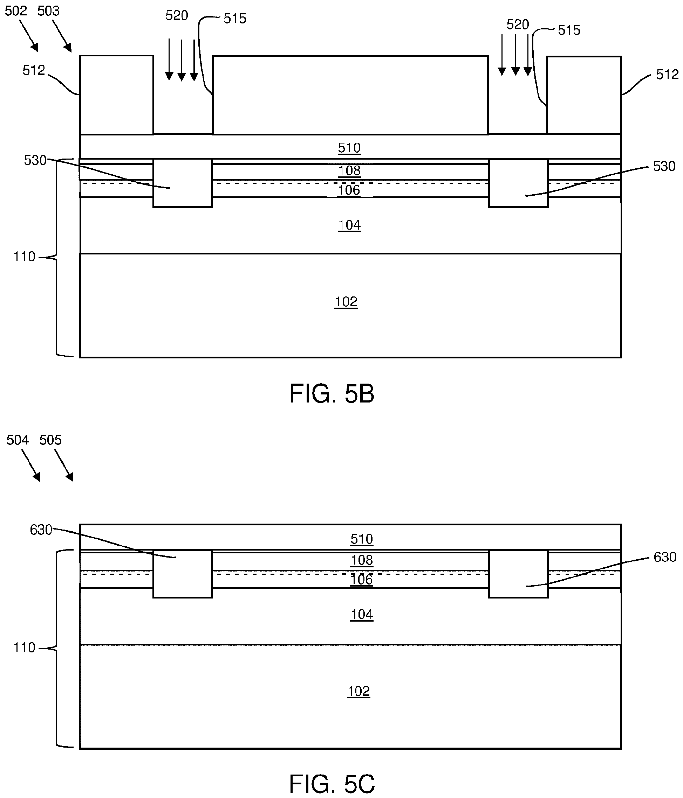

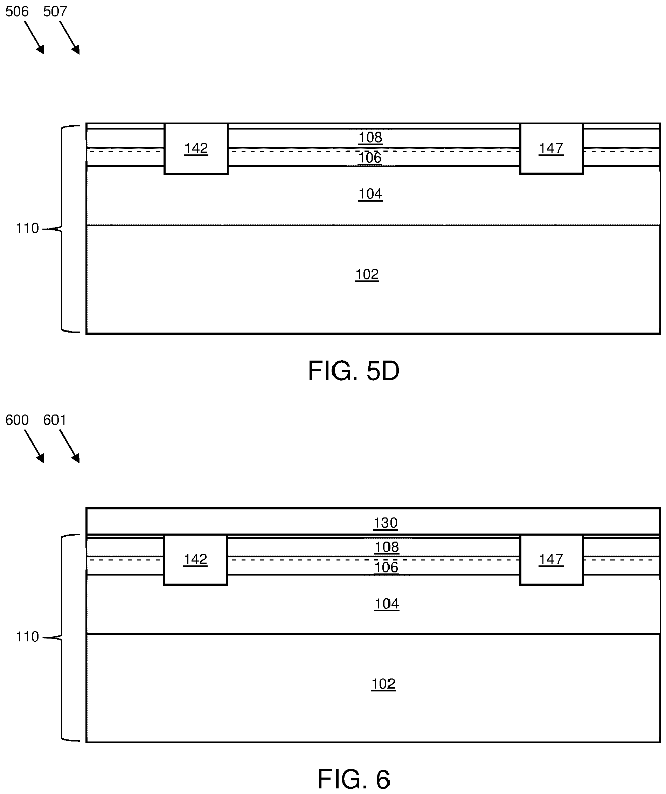

In block 304 of FIG. 3, and as depicted in steps 500, 502, 504, and 506 of FIGs 5A, 5B, 5C, and 5D, an embodiment of the method may optionally include forming doped (e.g., ion-implanted) source and drain regions 142 and 147. As depicted in a step 500 of FIG. 5A, forming source and drain regions 142 and 147 may include forming a sacrificial dielectric layer 510 on or over the semiconductor substrate 110. As discussed previously, in an embodiment, the sacrificial dielectric layer 510 may include materials selected from SiN, Al₂O₃, SiOz, AlN, and HfOz. The sacrificial dielectric layer 510 may be formed using one or more of low pressure chemical vapor deposition (LPCVD), atomic layer deposition (ALD), sputtering, physical vapor deposition (PVD), plasma-enhance chemical vapor deposition (PECVD), MOCVD, MBE, inductively coupled plasma (ICP) deposition, electron-cyclotron resonance (ECR) deposition, or other suitable techniques. In other embodiments, the sacrificial dielectric layer 510 may be formed, *in-situ,* immediately after and in the same chamber or deposition system (e.g., MOCVD or MBE) as the growth of the semiconductor layers of semiconductor substrate 110. Structure 501 results.

Referring again to block 304 of FIG. 3 and to FIG. 5B and step 502, an embodiment of the method may include patterning an implant mask 512 and implanting a dopant species 520 through an opening 515 in implant mask 512 into the semiconductor substrate to form the implant regions 530 within the semiconductor substrate 110. Once the implant mask 512 is patterned, the dopant species 520 may be implanted through the sacrificial dielectric layer 510 and into the semiconductor substrate 110. In an embodiment, one or more of Si, Ge, O, or other suitable n-type dopant(s) may be implanted into the semiconductor substrate through the implant mask form the implant regions 530. Structure 503 results.

Still referring to block 304 of FIG. 3 and now to FIG. 5C and step 504, an embodiment of the method may include removing the implant mask 512 before activating the dopant species in implant regions 530 to complete the formation of the source and drain regions 142 and 147 within the semiconductor substrate 110. The implant mask 512 may be removed using one or more conventional wet chemical and plasma ashing technique(s). Structure 505 results.

Referring again to block 304 of FIG. 3, and now to FIG. 5D and step 506, an embodiment of the method may include activating the implant regions 530 of structure 505 of FIG. 5C to form the source and drain regions 142, 147 and removing the sacrificial dielectric layer 510. According to an embodiment, the implant regions 530 may be activated by annealing the semiconductor substrate 110 using an activation anneal at a temperature of between about 900°C and about 1,500°C. In some embodiments, the duration of the activation anneal may be between about 60 seconds and about 600 seconds. In other embodiments, the duration of the activation anneal may be between about 10 seconds and about 2,000 seconds. After activating the implant regions 530 to create source and drain regions 142, 147, the sacrificial dielectric layer 510 may be removed using wet and or dry etching. Structure 507 results.

Referring now to block 306 of FIG. 3, now to FIG. 6 and step 600, an embodiment of the method may include forming the first dielectric layer 130 on or over the semiconductor substrate 110 of the structure 507 of FIG. 5D. In other embodiments of the method that do not include implanted ohmic contacts (not shown), the first dielectric layer 130 may be formed the semiconductor substrate 110 is formed in block 302 of FIG. 3 and step 400 of FIG. 4. As discussed previously, in an embodiment, the first dielectric layer 130 may include materials selected from SiN, Al₂O₃, SiOz, AlN, and HfOz. The first dielectric layer 130 may be formed using one or more of LPCVD, ALD, sputtering, PVD, PECVD, MOCVD, MBE, ICP deposition, ECR deposition, or other suitable techniques. Structure 601 results.

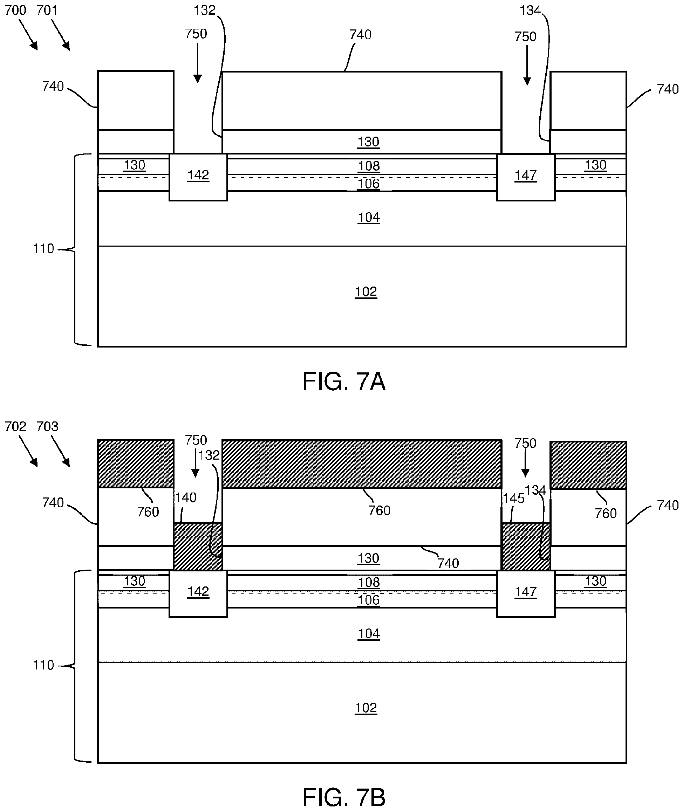

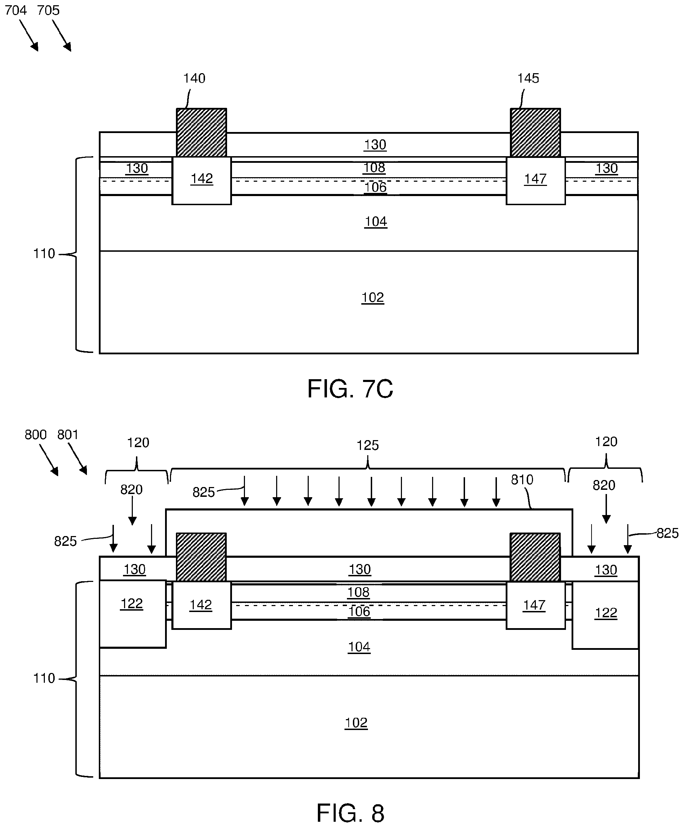

Referring now to block 308 of FIG. 3, and as depicted in steps 700, 702, and 704 of FIGs 7A, 7B, and 7C, an embodiment of the method may include forming source and drain electrodes 140 and 145. In an embodiment, and referring to FIG. 7A, forming the source and drain openings 132, 134 and may include dispensing a resist layer 740 over the first dielectric layer 130 and patterning the resist layer 740 to form resist openings 750. In an embodiment, source and drain electrodes 140 and 145 may be created by etching through the first dielectric layer 130 in areas exposed by the resist openings 750 to form source and drain openings 132 and 134. Etching the first dielectric layer 130 (e.g., SiN) may include etching using one or more dry and/or wet etch technique(s) such as reactive ion etching (RIE), ICP etching, ECR etching, and wet chemical etching according to an embodiment. Suitable wet-etch chemistries may include hydrofluoric acid (HF), buffered HF, buffered oxide etch (BOE), phosphoric acid (H₃PO₄), or other suitable wet etchant(s), according to an embodiment. These dry etching techniques may use one or more of sulphur hexafluoride (SF₆), di-carbon hexafluoride (C₂F₆), carbon tetrafluoride (CF₄), tri-fluoromethane (CHF₃) or other suitable chemistry, to remove SiN, according to an embodiment. In an embodiment, the etchant used to etch the first dielectric 130 may selectively etch a portion of the first dielectric layer 130 and then stop on an etch stop layer (not shown, e.g., Al₂O₃ or AlN) formed between the first dielectric layer 130 and the semiconductor substrate 110. In an embodiment, etching the etch stop layer (e.g., an Al₂O₃ or AlN etch stop layer) may include wet and/or dry etch techniques. In other embodiment(s), dry etching of the etch stop layer (e.g., an AlN or Al₂O₃ etch stop) may include dry etching using suitable techniques (e.g., RIE, ICP, or ECR) in conjunction chlorine-based chemistry such as Cl₂, boron trichloride (BCl₃), or other suitable dry-etch chemistries. Structure 701 results.

Referring now to block 308 of FIG. 3, and step 702 of FIG. 7B, an embodiment of the method may include forming the source and drain electrodes 140 and 145 in the source and drain openings 132 and 134 over the first dielectric layer 130. In an embodiment, the method may include depositing ohmic contact metal 760 over the resist layer 740 and into the source and drain openings 132 and 134. In an embodiment, the ohmic contact metal 760 may contain one or more conductive layers that include Ti, Ta, Al, Mo, Au, Ni, Si, Ge, platinum (Pt), tungsten (W), and or other refractory metals, that when annealed, may form an ohmic contact with the source and drain regions 142, 147. In an embodiment, the ohmic contact metal 760 may include a stack deposited on the substrate that includes Ti, Al, and Au. In an embodiment, to form the ohmic contact metal 760, a Ti layer may be disposed over the semiconductor substrate 110 in the openings 132, 134, an Al layer may be disposed over the Ti layer, a barrier layer formed from Mo or other suitable barrier metal such as Ni or tungsten, may be disposed over the Al layer, and an Au layer may be disposed over the barrier layer. In an embodiment, the ohmic contact metal 760 may be deposited by evaporation. In other embodiments, the ohmic contact metal 760 may be deposited by sputtering, PVD, or other suitable deposition techniques. In an embodiment, the Ti layer may be between about 100 angstroms and 200 angstroms thick, the Al layer may be between about 600 angstroms and 1500 angstroms thick, the Mo layer may be between about 200 angstroms and 700 angstroms thick, and the Au layer may be between about 300 angstroms and 1000 angstroms thick. In other embodiments, other metals may be substituted (e.g., Ni or Pt may be substituted for Mo or Ta may be used in addition to Ti, above or below Ti, to or substituted for Ti) and other thicknesses may be used. In an embodiment, the resist layer 740 may be configured in a lift-off profile, wherein the openings of the resist layer 740 have a retrograde profile, allowing the metal not deposited into resist openings 750 to "lift off" when dissolved in solvents. In other embodiments, the source and drain electrodes 140 and 145 may be patterned by dry etching (not shown). Structure 703 results.

Referring again to block 308 of FIG. 3, and as depicted in step 704 of FIG. 7C, an embodiment of the method may include annealing source and drain electrodes 140 and 145. In an embodiment, annealing the source and drain electrodes 140, 145 may include an annealing step used to alloy the ohmic contact metal 760 of FIG. 7B, resulting in ohmic contacts to the source and drain regions 142 and 147 formed in semiconductor substrate 110 that form source and drain electrodes 140 and 145. In an embodiment, the annealing step may be accomplished by rapid thermal annealing. In an embodiment, the ohmic metal 760 of FIG. 7B that remains in source and drain openings 132 and 134 of FIG. 7B may be alloyed at a temperature of between about 400 degrees Celsius and about 700 degrees Celsius for between about 15 seconds and about 60 seconds. In other embodiments the ohmic metal 760 of FIG. 7B may be annealed at between about 300 degrees Celsius and about 800 degrees Celsius for between about 10 seconds and about 600 seconds, though other higher or lower temperatures and times may be used. In an embodiment, the metal stack used to form the ohmic metal 760 (e.g., Ti, Al, Mo, and Au) may form the source and drain electrodes 140 and 145. Structure 705 results.

Without departing from the scope of the inventive subject matter, source and drain electrodes 140, 145 may be formed using alloyed ohmic contacts (not shown). In these embodiments, source and drain regions may not be formed. Rather, ohmic contact to semiconductor substrate 110 is accomplished by high temperature annealing of the ohmic metals (e.g., Ti, Al, Mo, Au may be used to form an ohmic contact to the channel 107, as described above).

Still referring to block 308, and now to step 800 of FIG. 8, in an embodiment, the method may include creating isolation regions 120. Forming the isolation regions 120 may include dispensing and patterning a resist mask 810 over the first dielectric layer 130 and then defining openings 820 in the resist mask 810. Using ion implantation, a dopant species 825 (e.g., one or more of oxygen, nitrogen, boron, arsenic, and helium) may be driven into the semiconductor substrate 110 to create high resistivity regions 122. In an embodiment, the energy and dose of the implant may be configured to create a sufficient amount of damage in the crystal structure of the semiconductor substrate 110 such that the semiconductor substrate is substantially high resistivity or semi-insulating within the high resistivity regions 122 of the isolation regions 120. In other embodiments (not shown), forming the isolation regions 120 may include, first, etching some or all of the semiconductor layers in the semiconductor substrate 110 and then ion implanting to enhance the resistivity in the remaining semiconductor layers and/or the host substrate 102. In some embodiments, the isolation regions 120 may be formed after forming the source and drain electrodes 140, 145. In other embodiments, the isolation regions 120 may be formed before forming the source and drain electrodes 140, 145. Structure 801 results.

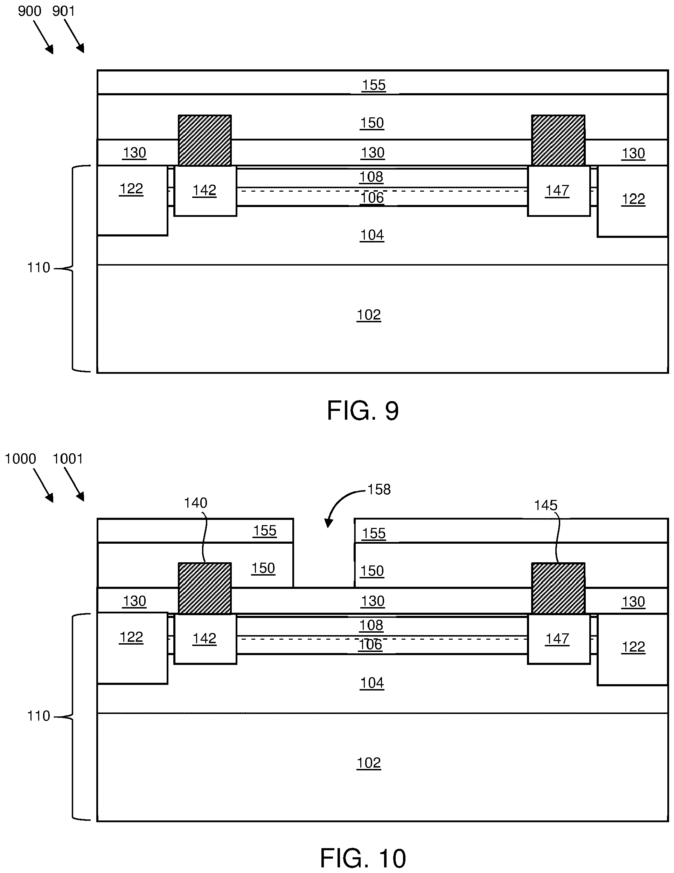

Referring now to block 310 of FIG. 3, now to FIG. 9 and step 900, an embodiment of the method may include forming the second dielectric layer 150 and the third dielectric layer 155 on or over the semiconductor substrate 110 of the structure 801 of FIG. 8. As discussed previously, in an embodiment of the method, the second and third dielectric layers 150, 155 may include materials selected from SiOz, TEOS, organo-silicate glass, porous SiOz, SiN, SiON, Al₂O₃, AlN, and HfOz. The second and third dielectric layers 150, 155 may be formed over the first dielectric layer 130 using one or more of LPCVD, ALD, sputtering, PVD, PECVD, MOCVD, MBE, ICP deposition, ECR deposition, or other suitable techniques. Structure 601 results.

Referring next to blocks 312, 314, and 316 of FIG. 3 and steps 1000, 1100, 1102, 1104, 1106, 1200, 1202 of FIGs 10, 11A, 11B, 11C, 11D, 12A, and 12B, in an embodiment, forming the gate electrode 160, 260 of the GaN HFET devices 100, 200 of FIGs 1 and 2 may include forming the upper opening 158 in the third dielectric layer 155 and the second dielectric layer 150, forming the lower opening 136 within the upper opening 158, and forming the gate electrode 160 within the lower opening 136, the upper opening 158, and over a portion of the third dielectric layer 155 adjacent the upper opening 158.

Referring now to block 312 of FIG. 3 and to FIG. 10 and step 1000, the upper opening 158 may be created in the second and third dielectric layers 150, 155 between the source and drain electrodes 140, 145, according to an embodiment of the method. In an embodiment of the method, a resist layer (e.g., photo resist or e-beam resist, not shown) may be patterned to create an opening in the resist layer. Using the opening created in the resist layer, the third dielectric layer 155 and the second dielectric layer 150 may be etched dry and/or wet chemical etch(s) analogous to that described in connection with FIG. 7A, step 700, to form the upper opening 158, thus exposing the first dielectric layer 130, according to an embodiment. In an embodiment, separate etch steps may be used to etch the third dielectric layer 155 (e.g., SiN) and the second dielectric layer 150 (e.g., TEOS). In some embodiments, the etch of the second dielectric layer 150 (e.g., TEOS) may be selective to the first dielectric layer 130 (e.g., SiN). In other embodiments, etch stop layers (e.g., AlN or Al₂O₃) may be formed between the second dielectric layer 150 and the first dielectric layer 130 (not shown) and/or between the second dielectric layer 150 and the third dielectric layer 155 (not shown). Analogous to the etch stop described in connection with FIG. 7A, step 700, these etch stops may be used to selectively block the etch of the third dielectric layer 155 and/or the first dielectric layer 150 so that the underlying dielectric layer (e.g., first dielectric layer 130 and/or second dielectric layer 150) remain un-etched after the etch stop layer(s) are removed (e.g., with wet chemistry that does not etch the underlying layer). The resist layer may then be removed using wet stripping and/or plasma ashing, according to an embodiment (not shown). Structure 1001 results.

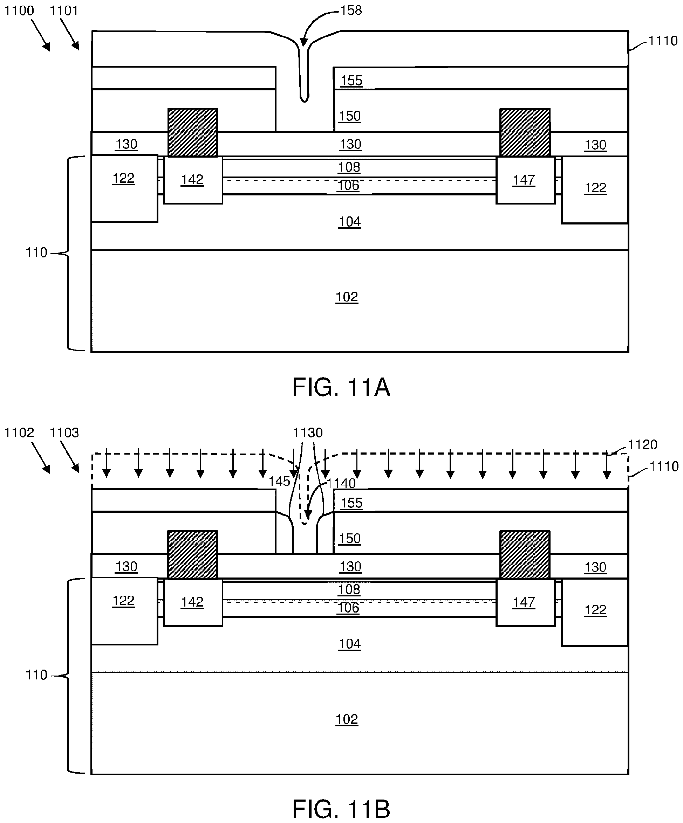

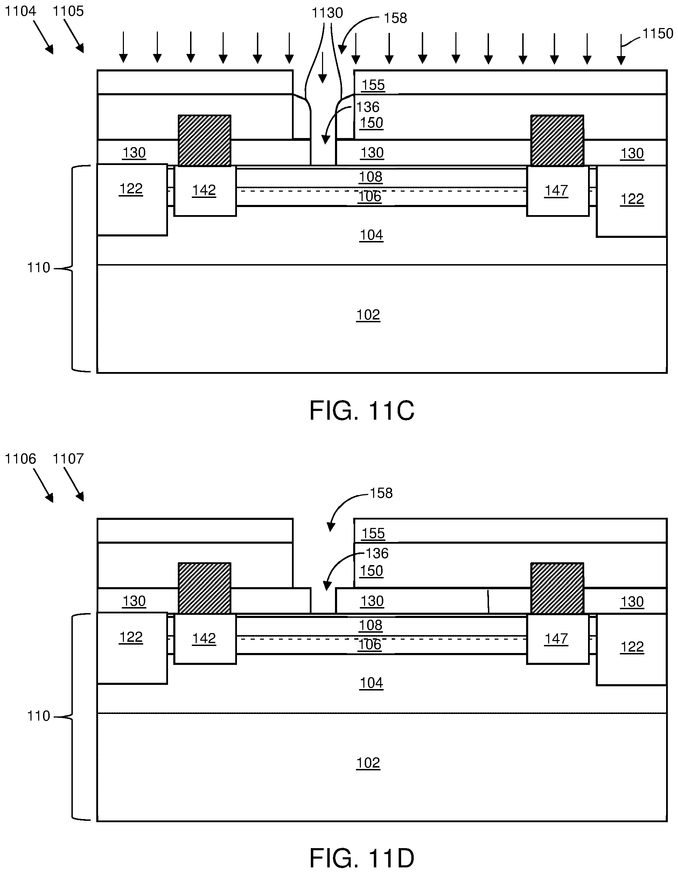

Referring now to block 314 of FIG. 3 and to FIGs 11A, 11B, 11C, and 11D and steps 1100, 1102, 1104, and 1106, the lower opening 136 may be formed in the first dielectric layer 130 and within the upper opening 158, according to an embodiment of the method. In an embodiment, the lower opening 136 may be formed by forming a sacrificial masking layer 1110, patterning the sacrificial masking layer 1110, and then etching the underlying first dielectric layer 130 to form the lower opening 136.

Referring now to FIG. 11A, step 1100, in an embodiment of the method, the sacrificial masking layer 1110 may be formed using, e.g., TEOS or other suitable dielectric material. The sacrificial masking layer 1110 may be formed over the third dielectric layer 155 outside of the upper opening 158 and over the edges of the second dielectric layer 150 and over first dielectric layer 130, within the upper opening 158. The sacrificial masking layer 1110 may be formed using one or more of LPCVD, ALD, sputtering, PVD, PECVD, MOCVD, MBE, ICP deposition, ECR deposition, or other suitable techniques. The sacrificial masking layer may have a thickness between about 500 angstroms and 10000 angstrom, though other thicknesses may be used. Structure 1101 results.

Referring now to FIG. 11B, step 1100, in an embodiment of the method, the sacrificial masking layer 1110 may be patterned using anisotropic etching 1120 to form a lower opening hard mask (i.e., "hard mask layer") 1130 and to expose the first dielectric layer 130 within a hard mask opening 1140. Anisotropically etching the sacrificial masking layer 1110 may include etching using one or more dry etch techniques such as RIE, ICP etching, ECR etching, according to an embodiment. These dry etching techniques may use one or more of SF₆, C₂F₆, CF₄, CHF₃ or other suitable chemistry, to anisotropically etch the sacrificial masking layer 1110 and create the hard mask opening 1140, according to an embodiment. Structure 1103 results.

Referring now to FIG. 11C, step 1104, in an embodiment of the method, the first dielectric layer 130 may be etched with a suitable etchant 1150 to form the lower opening 136 within the upper opening 158. Etching the first dielectric layer 130 to form the lower opening 136 may include etching using one or more dry etch techniques such as reactive ion etching (RIE), ICP etching, ECR etching, according to an embodiment. These dry etching techniques may use one or more of sulphur hexafluoride (SF₆), di-carbon hexafluoride (C₂F₆), carbon tetrafluoride (CF₄), tri-fluoromethane (CHF₃) or other suitable chemistry, to etch the first dielectric layer 130 and create the lower opening 136, according to an embodiment. In other embodiments, wet etching may be used to create the lower opening 136. Structure 1105 results.

Referring now to FIG. 11D, step 1106, in an embodiment of the method, the hard mask 1130 of FIG. 11C may be removed within the upper opening 158. Removing the hard mask 1130 may include etching using one or more dry etch techniques such as reactive ion etching (RIE), ICP etching, ECR etching, according to an embodiment. These dry etching techniques may use one or more of sulphur hexafluoride (SF₆), di-carbon hexafluoride (C₂F₆), carbon tetrafluoride (CF₄), tri-fluoromethane (CHF₃) or other suitable chemistry, to remove the hard mask 1140, according to an embodiment. In other embodiments, wet etching may be used to remove the hard mask 1130. Structure 1107 results.

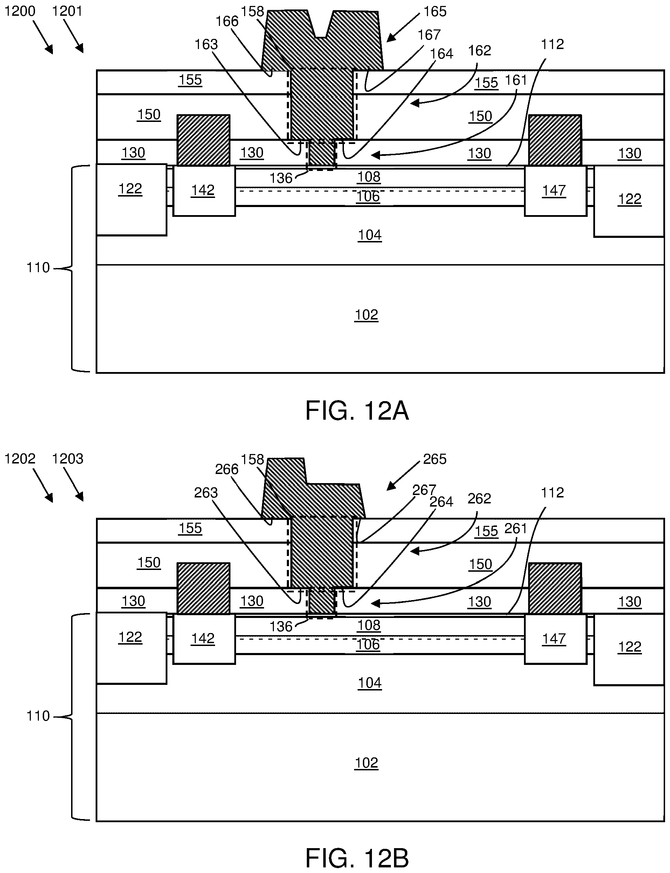

Referring now to block 316 of FIG. 3 and FIGs 12A and 12B steps 1200 and 1202, in an embodiment, one or more layers of gate metal may then be deposited and patterned to form the gate electrodes 160, 260 of FIGs 1 and 2 over the upper substrate surface 112 of the semiconductor substrate 110 with the lower opening 136 and over the first dielectric layer 130 within the upper opening 158, and over the third dielectric 155. In an embodiment, forming the gate electrodes 160, 260 may include forming first gate regions 161, 261 within the lower opening 136, forming second gate regions 162, 262 above the first gate regions 161, 261 wherein forming the second gate regions 162, 262 may include forming first protruding regions 163, 263 extending over the first dielectric layer 130 between the lower opening 136 and the source electrode 140 and forming second protruding regions 164, 264 extending over the first dielectric layer 130 between the lower opening 136 and the drain electrode 145. Forming the gate electrodes 160, 260 may also include forming a third gate region 165, 265 formed above the second gate region 162, wherein forming the third gate regions 165, 265 may include forming third protruding regions 166, 266 that extends over the third dielectric layer 155 between the upper opening 158 and the source electrode 140. Forming the gate electrode 160 of FIG. 1 may also include forming the fourth protruding regions 167 that extends over the third dielectric layer 155 between the upper opening 158 and the drain electrode 145.

In an embodiment, gate electrodes 160, 260 may be formed using, e.g., the lift-off resist technique, analogous to the description given for FIG. 7B and step 702. Depositing gate metal to form the gate electrodes 160, 260 may include depositing a multi-layer stack that includes one or more metal layers and/or other suitable materials, according to an embodiment of the method. In an embodiment, a first layer within the multi-stack used to form the gate electrode 160 may include Ti, Ni, Pt, Cu, Pd, Cr, W, Ir, poly-silicon or other suitable materials. The first layer may contact the semiconductor substrate 110 (or an optional gate dielectric formed over the semiconductor substrate 110 as described below) and the first dielectric layer 130 within the lower opening 155, may contact the edges of second and third dielectric layers 150, 155 within upper opening 158, and may contact the third dielectric layer 155 outside the upper opening 158, according to an embodiment. In an embodiment, the first layer may be between about 30 and about 2,000 angstroms in thickness, although other thickness values may be used. One or more layers that act as conductive layers may be deposited over the first layer to form the gate electrodes 160, 260, according to an embodiment. In an embodiment, the conductive layer(s) may include Au, Ag, Al, Cu, Ti or other substantially conductive materials. The conductive layer(s) may be between about 50 and about 20,000 angstroms in thickness, although other thickness values may be used, according to an embodiment. Optionally, and in some embodiments, one or more barrier metal layers may be placed between the first layer and the conductive layer(s), where the barrier metal layer(s) may include materials such as Ni, Pt, Cu, Pd, Cr, W, Ir or other substantially refractive materials that act as a barrier between the portion of the first layer and the conductive layer(s). In accordance with an embodiment, the barrier metal layer(s) may be between about 50 and about 10,000 angstroms in thickness, although other thickness values may be used. In an embodiment, the various layers used to form gate electrodes 160, 260 may be deposited by evaporation, sputtering, PVD, ALD, or other suitable deposition technique(s). Structures 1201, 1203 result.

It should be appreciated that other methods may be used to form the gate electrodes 160, 260 without departing from the scope of the inventive subject matter. In other embodiments, gate metal may be disposed over a gate dielectric such as SiO2, HfO2, Al2O3, or similar materials (not shown). The gate dielectric may be deposited over and above the upper substrate surface 112, according to an embodiment. In still other embodiments, the gate electrodes 160, 260 may be formed using gate metal that is deposited over the semiconductor substrate 110 and is then defined by patterning photo resist, and then etching the gate metal (not shown). In whichever embodiment or method is selected to form gate electrodes 160, 260 gate metal may then be deposited using the methods described in connection with the formation of gate electrodes 160, 260 shown in FIGs 12A and 12B.

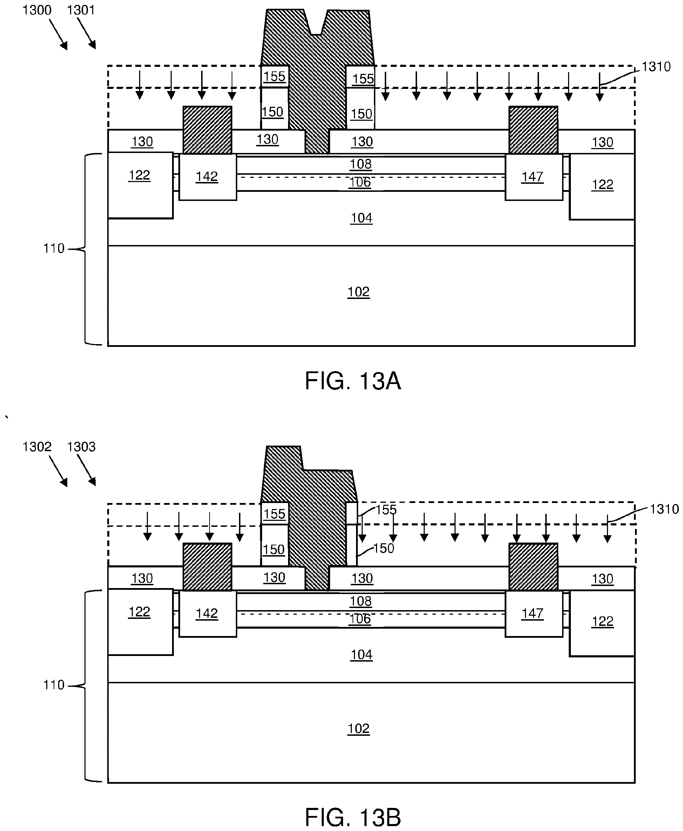

Referring now to block 318 of FIG. 3 and to FIGs 13A and 13B, steps 1300, 1302, an embodiment of the method for forming the GaN HFET devices 100, 200 of FIGs 1-2 may include etching the second and third dielectric layers 150, 155 at the sides of the gate electrodes 160, 260. In an embodiment, the etching of the second and third dielectric layers may be masked by the third and fourth protruding regions 166, 167, 266, 267 of the gate electrodes 160, 260. The etching of the second and third dielectric layers 150, 155 may include anisotropically etching 1310 using one or more dry etches such as RIE, ICP etching, ECR etching, according to an embodiment. In an embodiment, the anisotropic etching 1310 of the second and third dielectric layer may be selective to the first dielectric layer 130 (or, in some embodiments, an etch stop (e.g., Al₂O₃ or AlN) that is formed over or as part of the first dielectric layer 130) so as to not etch or to minimally etch the first dielectric layer 130 after the second and third dielectric layers 150, 155 have completed etching. These dry etching techniques may use one or more of SF₆, C₂F₆, CF₄, CHF₃ or other suitable chemistry, to anisotropically etch the portions of the second and third dielectric layers 150, 155, according to an embodiment. Structures 1301, 1303 result.

Referring now to block 320 of FIG. 3 and FIGs 14A, 14B, 14C, 14D, 15A, 15B, 16A, and 16B, and steps 1400, 1402, 1404, 1406, 1500, 1502, 1600, and 1602, an embodiment of the method may include forming optional spacer layers 169, 269 forming the fourth dielectric layer 180 over the spacer layers 169, 269 and forming the field plate 190 over a the fourth dielectric layer 180 and over a portion of the gate electrode 160.

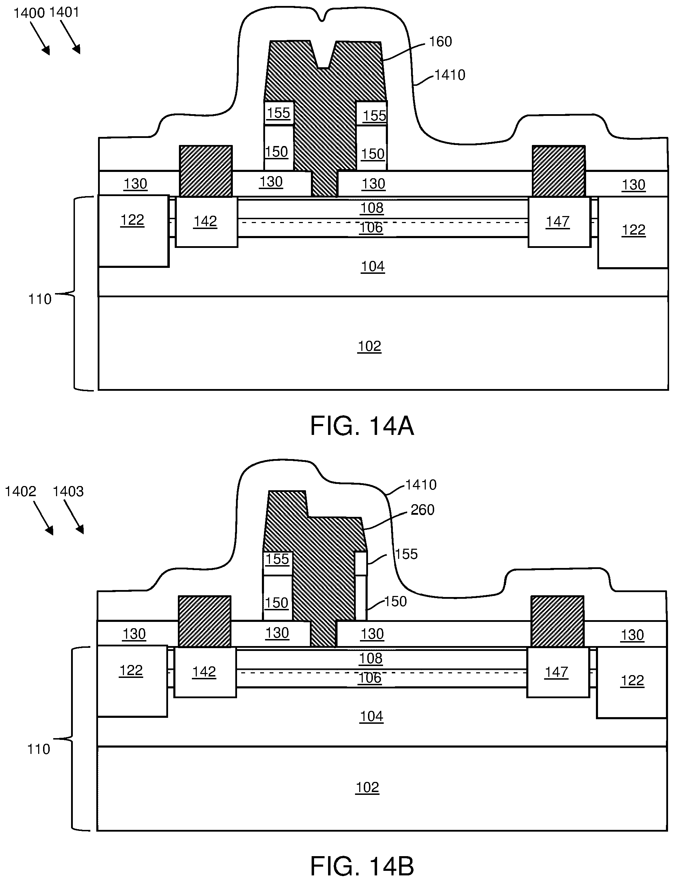

Referring now to FIGs 14A and 14B and steps 1400 and 1402, an embodiment of the method may include forming the spacer layers 169, 269. In an embodiment, and as shown in FIGs 14A and 14B, forming the spacer layers 169, 269 may include conformally depositing a blanket dielectric layer 1410 over the gate electrode 160, the source and drain electrodes 140, 145, and over the first dielectric layer 130. Structures 1401, 1403 result.

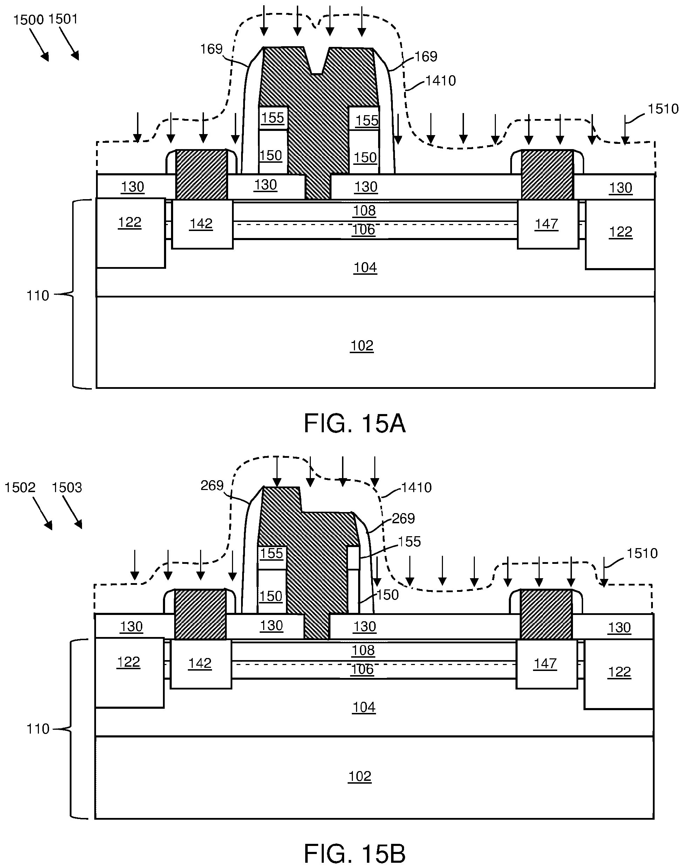

Referring now to FIGs 15A and 15B, in an embodiment of the method, depositing the blanket dielectric layer 1410 may be followed by steps 1404 and 1406 of anisotropically etching the blanket dielectric layer 1410 of structures 1401, 1403. The anisotropic etching of the blanket dielectric layer 1410 may be accomplished by using a dry etch 1510 to form spacer layers 169, 269 along the vertical sidewall of the second and third gate regions 162, 165, 262, 265 and the portions of the second and third dielectric layers 150, 155 adjacent the second gate regions 162, 262. The methods used to anisotropically etch the dielectric layer 1410 to create the spacer layers 169, 269 are analogous to those used to form lower opening hard mask 1130 as described in connection with FIG. 11C, step 1104 and are not repeated here for the sake of brevity. Structures 1501, 1503 result.

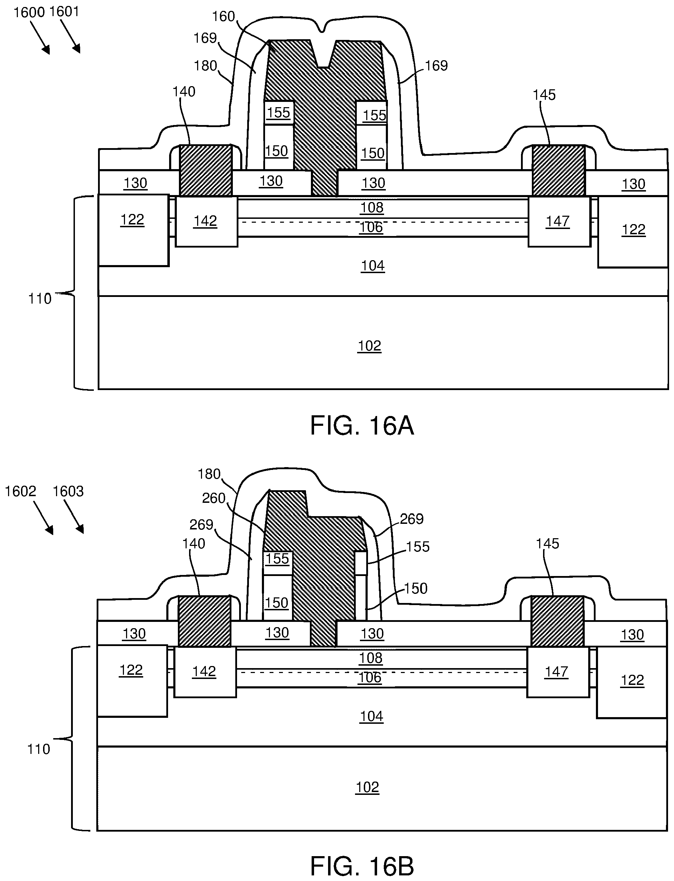

Referring now to FIGs 16A and 16B and steps 1600, 1602, an embodiment of the method may include forming the fourth dielectric layer 180 over the source and drain electrodes 140,145, the gate electrodes 160, 260, the exposed edges of the second and dielectric layers 150, 155, the spacer layers 169, 269, and the first dielectric layer 130 of structures 1405 and 1407 of FIGs 14C and 14D, according to an embodiment. In an embodiment, the fourth dielectric layer 180 may include one of SiN, Al₂O₃, SiOz, HfO₂, ITO, diamond, poly-diamond, AlN, BN, SiC, or a combination of these or other insulating materials. The total thickness of the layers used to form the fourth dielectric layer 180 may be between about 100 and about 10,000 angstroms in thickness, although other thickness values may be used. The fourth dielectric layer 180 may be deposited using LPCVD, PECVD, sputtering, PVD, ALD, Cat-CVD, HWCVD, ECR CVD, CVD, ICP-CVD, a combination of these or other suitable dielectric deposition technique(s). Structures 1601, 1603 result.

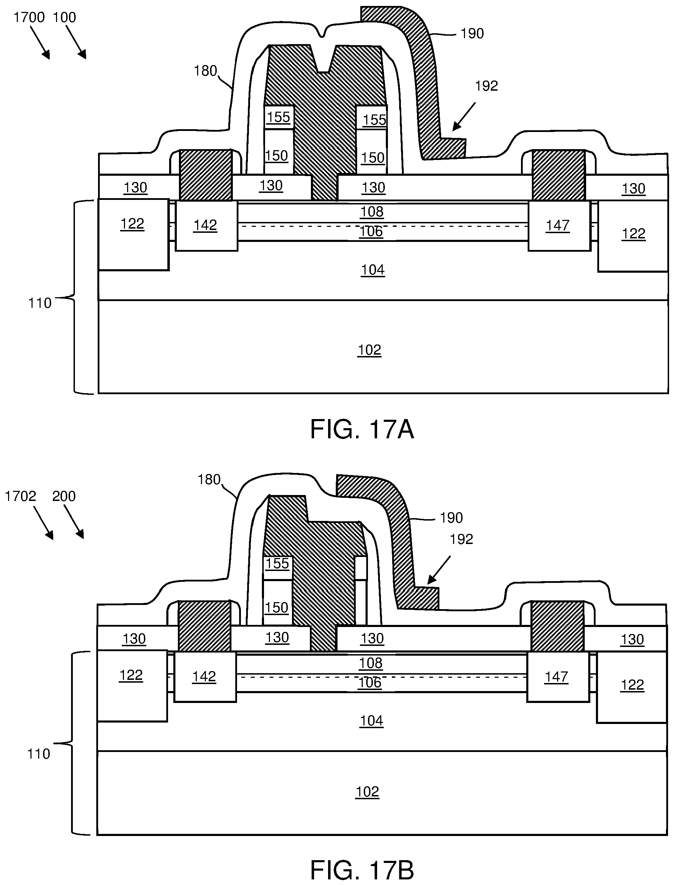

Referring now to FIGs 17A and 17B and steps 1700, 1702, in an embodiment, forming and patterning the field plate 190 may be accomplished by applying and patterning resist layers (not shown), depositing the field plate 190, and removing the resist layers and overlying metal outside the field plate 190 in a lift-off configuration, analogous to step 702 in FIG. 7B. In an embodiment, the field plate metal is formed by depositing one or more adhesion and conductive metal layers into openings (not shown) patterned into resist layers applied to the partially-formed device as described above. In an embodiment, the adhesion layer(s) may be deposited first, followed by deposition of the conductive layer(s). In an embodiment, the adhesion and conductive layers may be deposited in the same deposition step. The adhesion layer(s) may include one of Ti, Ni, Cr or other suitable adhesion layer material(s). The adhesion layer(s) may be between about 50 and about 2,000 angstroms in thickness, although other thickness values may be used. The conductive layer(s) may include Cu, Au, Al, or Ag, although other suitable materials may be used. The conductive layer(s) may be between about 200 and about 40,000 angstroms in thickness, although other thickness values may be used. The adhesion and conductive layers used to form the field plate 190 may be deposited over and in contact with the fourth dielectric layer 180, according to an embodiment. In an embodiment, the adhesion layer(s) and conductive layer(s) may be formed by sputtering, evaporation, or electro-plating. In an embodiment, after applying and patterning resist layers and depositing the field plate 190, the resist layers and metals deposited over the resist layers and not included with the portions of the metal that contact the fourth dielectric layer 180, field plate 190 may be removed using solvents analogous to those described in conjunction with step 702 in FIG. 7B. In other embodiments, the field plate 190 may be formed by depositing adhesion and conductive layers that are then patterned by suitable dry or wet chemical etching techniques. In other embodiments (not shown), the fourth dielectric layer 180, third dielectric layer 155, and second dielectric layer may have one or more openings etched adjacent the gate electrode 160 so that the first field plate region 192 may contact one or more of the first dielectric layer 130, the second dielectric layer 150, and the third dielectric layer 155.

FIG. 17A depicts performing step 1700 described in the foregoing to realize the GaN HFET device 100 of FIG. 1. FIG. 17B depicts performing step 1702 to realize the GaN HFET device 200 of FIG. 2. It should be appreciated that additional process layers and features (not shown) may be added to the GaN HFET devices 100, 200 of FIGs 1 and 2.

A semiconductor device includes a semiconductor substrate, a first dielectric layer disposed over the upper surface of the semiconductor substrate, a second dielectric layer disposed over the first dielectric layer, a third dielectric layer disposed over the second dielectric layer, a lower opening formed in the first dielectric layer, an upper opening formed in the second dielectric layer and the third dielectric layer, wherein at least a portion of the upper opening overlaps a portion of the lower opening, and a control electrode formed within at least a portion of the lower opening and within a portion of the upper opening, wherein a portion of the control electrode is formed over the third dielectric layer.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

For the sake of brevity, conventional semiconductor fabrication techniques may not be described in detail herein. In addition, certain terminology may also be used herein for reference only, and thus are not intended to be limiting, and the terms "first", "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

## Claims

1. A semiconductor device comprising:
a semiconductor substrate comprising an upper surface and a channel;
a first dielectric layer disposed over the upper surface of the semiconductor substrate;
a second dielectric layer disposed over the first dielectric layer;
a third dielectric layer disposed over the second dielectric layer;
a lower opening formed in the first dielectric layer;
an upper opening formed in the second dielectric layer and the third dielectric layer, wherein at least a portion of the upper opening overlaps a portion of the lower opening; and
a control electrode formed within at least a portion of the lower opening and within a portion of the upper opening, wherein a portion of the control electrode is formed over the third dielectric layer.

2. The semiconductor device of claim 1, further comprising a first current-carrying electrode formed over the semiconductor substrate and electrically coupled to the channel within a first current-carrying opening in the first dielectric layer and a second current-carrying electrode formed within a second current-carrying opening in the first dielectric layer and electrically coupled to the channel, wherein the control electrode is formed between the first current-carrying electrode and the second current-carrying electrode, and wherein the first current-carrying electrode and the second current-carrying electrode are configured to support current flow through the channel.

3. The semiconductor device of claim 2, wherein the control electrode is configured as a gate electrode, the first current-carrying electrode is configured as a source electrode, and the second current-carrying electrode is configured as a drain electrode.

4. The semiconductor device of claim 3, wherein a fourth dielectric layer is formed over the gate electrode and a field plate is formed adjacent the gate electrode and over a at least portion of the fourth dielectric layer.

5. The semiconductor device of any of claims 2 to 4, wherein the control electrode includes:
a first region formed within the lower opening;
a second region formed above the first region, wherein the second region includes a first protruding region extending over the first dielectric layer between the lower opening and the first current-carrying electrode and a second protruding region extending over the first dielectric layer between the lower opening and the second current-carrying electrode; and
a third region formed above the second region, wherein the third region includes a third protruding region extending over the third dielectric layer between the upper opening and the first current-carrying electrode.

6. The semiconductor device of claim 5, wherein the third region of the control electrode includes a fourth protruding region extending over the third dielectric layer between the upper opening and the second current-carrying electrode.

7. The semiconductor device of claim 6, wherein a lateral length of the third protruding region is longer than a lateral length of the fourth protruding region.

8. The semiconductor device of claim 6 or 7, wherein a lateral length of the second protruding region is shorter than a lateral length of the fourth protruding region.

9. The semiconductor device of any preceding claim, wherein a dielectric constant of the first dielectric layer exceeds a dielectric constant of the second dielectric layer.

10. The semiconductor device of any preceding claim, wherein the first dielectric layer includes silicon nitride and the second dielectric layer includes a material selected from the group consisting of silicon dioxide, tetraethyl orthosilicate, organo-silicate glass, and porous silicon dioxide.

11. A gallium nitride transistor device comprising the semiconductor device of any preceding claim.

12. A method for forming a gallium nitride transistor device, the method comprising:
forming a semiconductor substrate comprising gallium nitride and further comprising an upper surface and a channel;
forming a first dielectric layer over the upper surface of the semiconductor substrate;
forming source-drain openings in the first dielectric layer;
forming a source electrode and a drain electrode over the semiconductor substrate within the source-drain openings;
forming a second dielectric layer over the first dielectric layer;
forming a third dielectric a third layer over the second dielectric layer;
forming an upper opening in the third dielectric layer and the second dielectric layer between the source electrode and the drain electrode;
forming a lower opening in the first dielectric layer, wherein at least a portion of the upper opening overlaps a portion of the lower opening; and
forming a gate electrode, wherein forming the gate electrode includes:
forming a first gate region within the lower opening;
forming a second gate region above the first gate region, wherein forming the second gate region includes forming a first protruding region extending over the first dielectric layer between the lower opening and the source electrode and a forming a second protruding region extending over the first dielectric layer between the lower opening and the drain electrode; and
forming a third gate region above the second gate region, wherein forming the third gate region includes forming a third protruding region that extends over the third dielectric layer between the upper opening and the source electrode.

13. The method of claim 12, wherein forming the first dielectric layer includes forming silicon nitride and forming the second dielectric layer in includes forming a material selected from the group consisting of silicon dioxide, tetraethyl orthosilicate, organo-silicate glass, and porous silicon dioxide.

14. The method of claim 12 or 13, wherein the second dielectric layer and the third dielectric layer are etched to terminate at a terminating end of the third protruding region.

15. The method of any of claims 12 to 14, wherein the method includes forming a hard mask layer within the upper opening, wherein the hard mask layer is used to form the lower opening.
